(19) Europäisches Patentamt

European Patent Office

Office européen des brevets

(11) **EP 1 566 644 B1**

(12) **FASCICULE DE BREVET EUROPEEN**

(45) Date de publication et mention
de la délivrance du brevet:
**28.01.2009 Bulletin 2009/05**

(51) Int Cl.:
***G01R 27/18*** *(2006.01)*

(21) Numéro de dépôt: **05290264.0**

(22) Date de dépôt: **07.02.2005**

(54) **Procédé de mesure des résistances de terre d'installations électriques, par une mesure d'impédance de boucle**

Verfahren zur Messung von Erdungswiderständen von elektrischen Einrichtungen durch Messung der Schleifenwiderstandes

Method for the measurement of earth resistances of electric installations by measuring the loop-impedance

(84) Etats contractants désignés:
**AT DE ES GB IT SI**

(30) Priorité: **18.02.2004 FR 0401624**

(43) Date de publication de la demande:
**24.08.2005 Bulletin 2005/34**

(73) Titulaire: **CHAUVIN-ARNOUX**
**92200 Neuilly sur Seine (FR)**

(72) Inventeurs:
- **Bougaud, Patrick**
 **75018 Paris (FR)**
- **Arnoux, Daniel**
 **75018 Paris (FR)**
- **Kantorowski, Bernard**
 **75018 Paris (FR)**
- **Arnoux, Axel**
 **75018 Paris (FR)**

(74) Mandataire: **Thinat, Michel**
**Cabinet Weinstein**
**56 A, rue du Faubourg Saint-Honoré**
**75008 Paris (FR)**

(56) Documents cités:
| | |
|---|---|
| **EP-A- 0 300 653** | **EP-A- 0 337 171** |
| **JP-A- 6 222 093** | **JP-A- 57 131 071** |
| **US-A- 5 514 964** | |

**Description**

L'invention concerne un procédé de mesure des résistances de terre d'installations électriques, par une mesure d'impédance de boucle, selon lequel on injecte à l'aide de moyens transformateurs générateurs de tension un courant dans la boucle et mesure ce courant à l'aide de moyens transformateurs de mesures de courant.

Les procédés de ce type, qui sont connus, utilisent deux transformateurs distincts pour l'injection du courant et la mesure du courant, qui sont réalisés sous la forme de deux pinces qui enserrent la boucle à mesurer suffisamment éloignées l'une de l'autre pour éviter toute inter-réaction mutuelle ou sous la forme de deux pinces réunies en une seule pince, ce qui impose une isolation magnétique parfaite entre les deux transformateurs.

Le document JP-A-06222093 décrit un procédé de mesure des résistances de terre d'installations électriques, par une mesure d'impédance de boucle, selon lequel on injecte à l'aide de moyens transformateurs générateurs de tension un courant dans la boucle et on mesure ce courant à l'aide de moyens transformateurs de courant.

La présente invention a pour but de pallier ces inconvénients.

Pour réaliser de but, le procédé selon l'invention est caractérisé en ce que l'on réunit les deux moyens transformateurs en un seul transformateur utilisé comme transformateur d'impédance et établit l'impédance de boucle en effectuant une pluralité de mesures permettant la détermination et l'élimination des paramètres du transformateur, par exploitation des résultats de mesure.

Selon une caractéristique avantageuse de l'invention, on effectue la pluralité de mesures avec des valeurs d'induction et de fréquence différentes.

Selon une autre caractéristique de l'invention, on fait varier l'induction par variation de la tension d'entrée primaire du transformateur.

Selon encore une autre caractéristique de l'invention, on mesure séparément la partie réelle et la partie imaginaire de la relation entre la tension d'entrée du transformateur et le courant injecté et calcule par exploitation des résultats de mesure, les parties résistive et inductive de l'impédance à mesurer et la valeur même de cette impédance.

L'invention sera mieux comprise, et d'autres buts, caractéristiques, détails et avantages de celle-ci apparaîtront plus clairement de la description explicative qui va suivre faite en référence aux dessins schématiques annexés donnés uniquement à titre d'exemple illustrant un mode de réalisation de l'invention et dans lesquels :

- la figure 1 donne le schéma électrique d'un transformateur parfait ;
- la figure 2 donne le schéma électrique équivalent d'un transformateur du type utilisé à titre de transformateur d'impédance selon l'invention ;
- la figure 3 donne le schéma électrique du transformateur selon la figure 1, les éléments étant ramenés au côté primaire ;
- la figure 4 illustre le schéma du transformateur dans une version simplifiée ; et
- la figure 5 illustre le schéma électrique d'un circuit de séparation des parties réelle et imaginaire d'un signal.

L'invention est fondée sur la découverte que la résistance de terre peut être mesurée directement au moyen seulement du transformateur de tension, ce qui permet de supprimer le transformateur de mesure de courant ainsi que l'isolation magnétique. Le transformateur de tension est alors utilisé comme transformateur d'impédance de la manière qui sera décrite ci-après et qui constitue un procédé de mesure comportant, comme étape préalable, une étude théorique destinée à établir la relation entre la tension appliquée aux bornes du côté primaire du transformateur et le courant primaire injecté en identifiant les paramètres du transformateur qu'il faut éliminer lors de l'établissement de l'impédance de boucle, et en faisant apparaître ces paramètres dans leur corrélation dans cette relation tension/courant et une étape de mesure permettant d'obtenir les valeurs à partir desquelles ces paramètres peuvent être déterminés et ensuite l'impédance de boucle établie, par calcul.

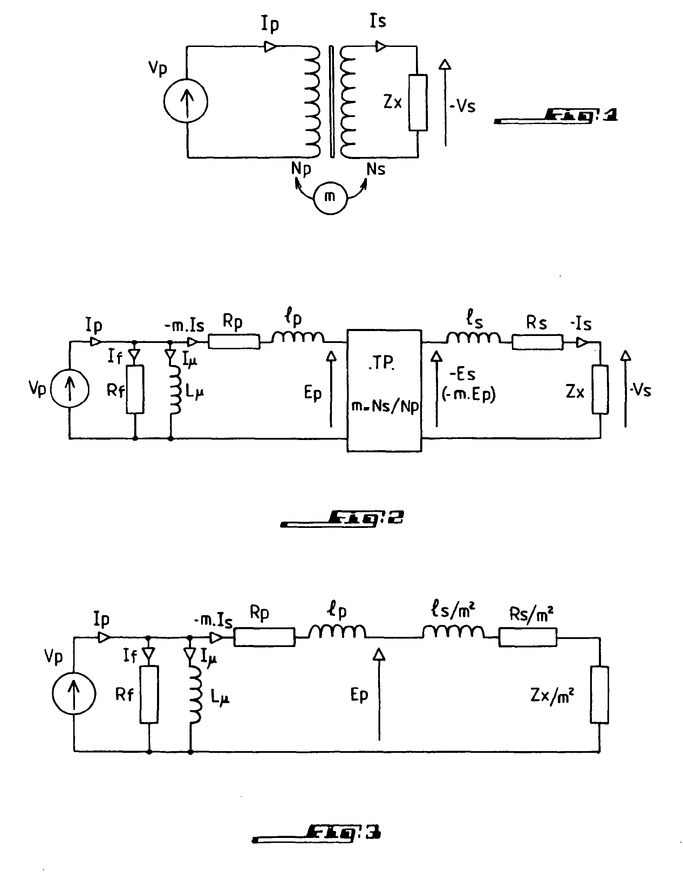

La figure 1 illustre sous forme d'un schéma équivalent d'un transformateur parfait, le but que l'invention souhaite réaliser, c'est-à-dire la mesure d'une impédance de boucle représentée par l'impédance $Z_x$ dans le circuit de l'enroulement secondaire $N_s$ du transformateur dont l'enroulement primaire est désigné par la référence $N_p$ et aux bornes duquel est appliquée la tension $V_p$. Cette tension fait circuler dans le primaire le courant $I_p$ qui induit dans le secondaire la tension $V_s$ engendrant le courant secondaire $I_s$, m étant le rapport des nombres de tours de l'enroulement secondaire $N_s$ et de l'enroulement primaire $N_p$.

Dans le cas de l'invention, le transformateur est réalisé sous forme d'une pince destinée à enserrer le conducteur de la boucle dont l'impédance doit être déterminée, cette boucle constituant l'enroulement secondaire $N_s$. Le nombre de tours de cet enroulement est par conséquent égal à 1.

Pour ce transformateur d'impédance parfait, qui n'a pas de perte de flux magnétique et dont le circuit magnétique présente une perméabilité infinie et est exempt de pertes de fer et de cuivre, l'impédance à mesurer est exprimée par l'équation :

$$Z_x = \frac{V_p m^2}{I_p}$$

Etant donné que $V_p$ est la tension appliquée aux bornes du primaire et est donc une grandeur connue et m une constante, il suffit de mesurer le courant primaire $I_p$ pour connaître l'impédance $Z_x$.

Mais, dans la réalité, le transformateur n'est pas parfait et a des pertes de flux magnétique, une perméabilité de circuit magnétique fini et des pertes de fer et de cuivre.

La figure 2 illustre le schéma équivalent du transformateur réel, le carré au milieu noté TP constituant le transformateur parfait de la figure 1 avec le rapport de tours m = $N_s/N_p$. Sur ce schéma, $R_f$ représente la résistance équivalente aux pertes fer du transformateur, $L_\mu$ l'inductance magnétisante du transformateur, c'est-à-dire l'image de la perméabilité non infinie du circuit magnétique, $I_f$ et $I_\mu$ les composantes du courant magnétisant du transformateur, $R_p$ la résistance de l'enroulement primaire, c'est-à-dire l'image des pertes cuivre, $I_p$ l'inductance de fuite du primaire, c'est-à-dire l'image des pertes de flux magnétiques, $R_s$ la résistance de l'enroulement secondaire, $I_s$ l'inductance de fuite du secondaire, $E_p$ la tension réelle générant le flux magnétique du transformateur et $E_s$ la tension résultante obtenue au secondaire.

Pour mesurer l'impédance $Z_x$ à travers le primaire du transformateur, tous les éléments du secondaire sont ramenés au primaire, ce qui donne le schéma équivalent représenté sur la figure 3.

Compte tenu du cas particulier de l'application, ce schéma équivalent peut se simplifier avec les hypothèses suivantes :

- l'enroulement $N_s$ est constitué par la boucle dont on veut mesurer l'impédance ; il en résulte que $N_s = 1$ et $I_s$ devient négligeable et peut être considéré comme étant égal à zéro et que $R_s = 0$.

- la valeur de $R_p$ est négligeable devant $Z_x N_p^2$   d'où $R_p \approx 0$.

- l'imposition d'un bobinage réparti du primaire permet également de supposer $I_s = 0$.

Le schéma équivalent peut donc être représenté sous la forme illustrée sur la figure 3, ce qui permet d'écrire :

$$\frac{I_p}{V_p} = \frac{1}{Z}$$

avec

$$\frac{1}{Z} = \frac{1}{R_f} + \frac{1}{L_\mu \omega} + \frac{1}{Z_x N_p^2}$$

Où $\omega = 2\pi f$, f étant la fréquence de la tension $V_p$.

En remplaçant résistance par conductance et impédance par admittance, on peut écrire l'équation précédente sous la forme :

$$\frac{I_p}{V_p} = C_f + Y_\mu + Y_x$$

avec :

$$C_f = \frac{1}{R_f} \; ; \; Y_\mu = \frac{1}{L_\mu \omega} \; ; \; Y_x = \frac{1}{Z_x N_p}$$

et

$$Z_x = \sqrt{R_x^2 + L_x^2 \omega^2}$$

Il ressort de cette équation qu'il suffit de connaître et/ou d'éliminer les termes $C_f$ et $Y_m$ pour déterminer $Y_x$ donc $Z_x$.

Ceci peut s'effectuer tout d'abord en appliquant une méthode indirecte qui consiste à effectuer tout d'abord une mesure à vide, pour déterminer $C_f$ et $Y_\mu$ et ensuite la mesure de boucle. Puis il suffit de déduire les valeurs $C_f$ et $Y_\mu$ en respectant les déphasages de chaque terme pour obtenir la valeur de $Z_x$.

Cette solution est satisfaisante sur le plan du principe mais n'est pas aisée à mettre en oeuvre, parce que l'opération de mesure s'effectue en deux temps, ce qui nécessite d'ouvrir la pince. La mesure est donc tributaire des variations des entrefers et de la section effective des entrefers.

Une deuxième méthode, appelée méthode directe, consiste à effectuer l'ensemble des mesures tout en maintenant fermée la pince, c'est-à-dire sans être obligé d'ouvrir celle-ci au cours de la phase des mesures. Ce procédé évite donc les variations mécaniques susceptibles de créer des erreurs de mesure du procédé indirect.

Le procédé de mesure directe permet de n'effectuer qu'une seule séquence de mesures pendant laquelle on détermine les grandeurs $C_f$, $Y_\mu$, et $Y_x$, c'est-à-dire l'impédance $Z_x$.

On décrira ci-après l'établissement de ces grandeurs ou valeurs :

Les pertes fer $C_f$ sont définies par la relation suivante :

$$P_{f_n} = P_{f_0} \left[ \left( \frac{B_n}{B_0} \right)^y \left( \frac{f_n}{f_0} \right)^z \left( \frac{e_n}{e_0} \right)^t \left( \frac{S_n}{S_0} \right) \right]$$

dans laquelle B désigne l'induction de travail du transformateur ; f la fréquence de fonctionnement, e l'épaisseur des tôles constituant le circuit magnétique, S la section effective du circuit magnétique, y, z, t des constantes dépendant de la nature du circuit magnétique, c'est-à-dire également de la perméabilité du circuit magnétique et ainsi de l'entrefer, $P_{f0}$ les pertes fer dépendant de la nature du circuit magnétique, obtenues à l'induction $B_0$, à la fréquence $f_0$ pour une épaisseur des tôles $e_0$ et une section effective $S_0$ du circuit magnétique.

D'autre part, la résistance équivalente aux pertes de fer peut être écrite sous la forme

$$P_f = \frac{V_p^2}{R_f} \quad \text{soit} \quad P_f = V_p^2 C_f$$

ce qui permet d'établir :

$$P_{f_n} = V_{p_n}^2 C_{f_n} \quad \text{et} \quad P_{f_0} = V_{p_0}^2 C_{f_0}$$

et, en introduisant ces termes dans l'équation précédente :

$$V_{p_n}^2 C_{f_n} = V_{p_0}^2 C_{f_0} \left(\frac{B_n}{B_0}\right)^y \left(\frac{f_n}{f_0}\right)^z \left(\frac{e_n}{e_0}\right)^t \left(\frac{S_n}{S_0}\right)$$

soit :

$$C_{f_n} = \frac{V_{p_0}^2}{V_{p_n}^2} C_{f_0} \left(\frac{B_n}{B_0}\right)^y \left(\frac{f_n}{f_0}\right)^z \left(\frac{e_n}{e_0}\right)^t \left(\frac{S_n}{S_0}\right)$$

L'épaisseur des tôles et la section du circuit magnétique étant constant, ce qui permet d'établir :

$\dfrac{e_n}{e_0} = \dfrac{s_n}{s_o} = 1$ , l'expression devient :

$$C_{f_n} = A_n C_{f_0} \left(\frac{B_n}{B_0}\right)^y \left(\frac{f_n}{f_0}\right)^z$$

Le terme $Y_\mu$ est l'image de l'inductance de magnétisation qui est de la forme :

$$L = \mu_0 \mu_e N_p^2 \frac{S_f}{L_f}$$

avec

$$\mu_e = \frac{1}{\dfrac{1}{\mu_r} + \dfrac{\varepsilon}{L_f}}$$

dans laquelle
$\mu_0$ est la perméabilité relative de l'air, $\mu_r$ la perméabilité relative du matériau magnétique, $\mu_e$ la perméabilité effective du circuit magnétique, $\varepsilon$ l'entrefer du circuit magnétique et $L_f$ la longueur du circuit magnétique.
Le terme $Y_x$ s'exprime par l'équation suivante :

$$Y_x = \frac{1}{Z_x N_p^2} = \frac{1}{N_p^2 \sqrt{R_x^2 + L_x^2 \omega^2}}$$

En analysant les 3 expressions ci-dessus, il s'avère que dans l'équation $\dfrac{I_p}{V_p} = C_f + Y_\mu + Y_x$ $C_f$ et $Y_\mu$ dépendent de la fréquence et de l'induction et $Y_x$ seulement de la fréquence.
La résolution de cette équation peut se faire selon deux méthodes, dont la première consiste à trouver une séquence de mesures permettant de déterminer séparément chaque terme et la seconde de traiter séparément les parties réelles et imaginaires de chaque terme, $C_f$ ne comportant qu'une partie réelle pure, $Y_\mu$ une partie imaginaire

pure et $Y_x$ une partie réelle et une partie imaginaire.

Concernant la deuxième méthode, on peut exprimer l'équation $\dfrac{I_p}{V_p}$ de la manière suivante :

$$\frac{i_p}{v_p} = C_f + \frac{1}{jL_\mu\omega} + \frac{1}{N_p^2}\left(\frac{1}{R_x + jL_x\omega}\right)$$

En multipliant par les expressions conjuguées pour scinder en parties réelle et imaginaire, on obtient :

$$\frac{i_p}{v_p} = \left(\frac{R_x}{N_p^2\left(R_x^2 + L_x^2\omega^2\right)} + C_f\right) - j\left(\frac{1}{L_\mu\omega} + \frac{L_x\omega}{N_p^2\left(R_x^2 + L_x^2\omega^2\right)}\right)$$

En regardant les lois de variation des parties réelle et imaginaire séparément, on constate que dans la partie réelle, l'expression

$$\frac{R_x}{N_p^2\left(R_x^2 + L_x^2\omega^2\right)}$$

est fonction de la fréquence f, tandis que le terme $C_f$ s'est révélé ne dépendre que de la fréquence f et de l'induction B. On connaît également la loi de variation selon le terme f ou B.

Par conséquent, en faisant varier l'induction B, il est possible de connaître $C_f$ et de déterminer le terme

$$\frac{R_x}{N_p^2\left(R_x^2 + L_x^2\omega^2\right)}$$

Si la fréquence est constante, le terme $C_f$ peut s'écrire sous la forme

$$C_{f_n} = A_n C_{f_0}\left(\frac{B_n}{B_0}\right)^y$$

Il ressort des considérations qui précèdent, qu'il est possible de déterminer $B_n$, $B_0$ et y et donc $C_f$ en faisant trois mesures de la partie réelle, avec trois valeurs différentes de B, c'est-à-dire de la tension $V_p$ appliquée aux bornes de l'enroulement primaire du transformateur d'impédance, c'est-à-dire de la pince de mesure.

Concernant la partie imaginaire J, le terme $\dfrac{1}{L_\mu\omega}$ est fonction de l'inductance B et de la fréquence f. Etant donné qu'on ne connaît pas la loi de variation en fonction de B dû à sa dépendance de $\mu_r$, et donc de la courbe B = $\mu$H qui est une fonction non linéaire, H étant le champ magnétique, on ne peut connaître $L\mu$ qu'en faisant varier la fréquence et à condition que $\mu_r$ soit constant.

Quant à l'expression

$$\frac{L_x\omega}{N_p^2\left(R_x^2 + L_x^2\omega^2\right)}$$

elle est fonction uniquement de la fréquence, ce qui permet de connaître la loi de variation.

Il ressort de ce qui précède, que l'on ne peut jouer que sur la fréquence pour déterminer $L\mu$, mais ceci revient aussi à faire varier le terme

$$\frac{L_x\omega}{N_\rho^2\left(R_x^2 + L_x^2\omega^2\right)}$$

Or le terme $(R_x^2 + L_x^2\omega^2)$ intervenant aussi dans la partie réelle, il est possible de connaître le terme $(R_x^2 + L_x^2\omega^2)$ pour deux valeurs de fréquence distinctes, puis de déterminer $L_\mu$ ensuite.

On obtient alors une nouvelle valeur $C_f'$ de $C_f$ telle que :

$$C_{f_n}' = A_n'C_{f_0}\left(\frac{B_n}{B_0}\right)^y \text{ avec } A_n' = A_n\left(\frac{f_n}{f_0}\right)^z$$

Il suffit alors de refaire trois mesures avec variations de l'induction B à cette fréquence pour déterminer $C_f'$.

Mais, en connaissant déjà le terme y, deux variations de B sont suffisantes pour déterminer $C_f'$. Dépendant de la nature du circuit magnétique, si le terme y est affecté par le changement de fréquence, 3 variations de B sont nécessaires pour arriver au même résultat.

Il résulte des considérations qui précèdent, qu'en cumulant trois mesures avec variations de l'inductance B à une fréquence $f_1$, puis deux mesures avec variation de B à une fréquence $f_2$, il est possible de déterminer les valeurs $R_x$ et $L_x$ et par conséquent, l'impédance $Z_x$.

Comme il vient d'être décrit, le procédé prévoit la séparation des parties réelle et imaginaires, ce qui peut être fait en appliquant sur le courant mesuré $I_p$ une double démodulation synchrone quadratique, à savoir une démodulation synchrone, en phase avec la tension appliquée $V_p$, permettant d'obtenir la partie réelle, et une démodulation synchrone, déphasée de 90° par rapport à la tension $V_p$, permettant d'obtenir la partie imaginaire.

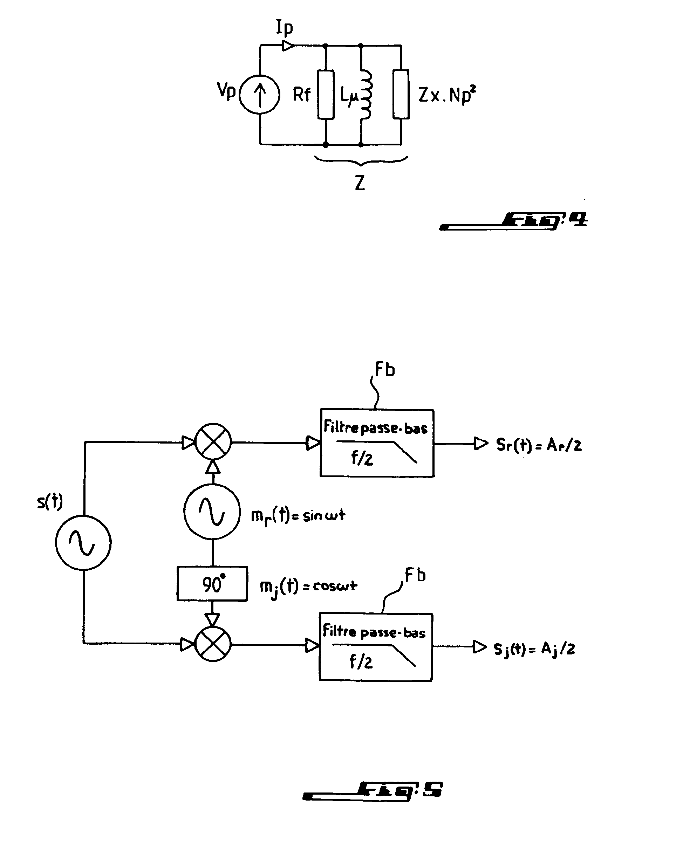

La figure 4 illustre le principe selon lequel peut s'obtenir la séparation des parties réelle et imaginaire. Sur cette figure, le signal mesuré dont les parties réelle et imaginaire doivent être séparées est indiqué par s(t). Ce signal peut être écrit sous la forme

$$S(t) = A_r \sin\omega t + A_j\cos\omega t,$$

dans lequel $A_r$ est le module de la partie réelle du signal s(t), $A_j$ le module de la partie imaginaire et $\omega$ la pulsation du signal mesuré.

La double démodulation synchrone quadratique se fait selon les formules

$$m_r(t) = \sin(\omega t + \varphi)$$

$$m_j(t) = \cos(\omega t + \varphi)$$

dans lesquelles :

$m_r(t)$ est la démodulation appliquée à la partie réelle du signal mesuré,
$m_j(t)$ la démodulation appliquée à la partie imaginaire de ce signal, équivalente à $m_r(t)$ déphasé de 90°, et
$\varphi$ le déphasage résiduel du système de démodulation.

En appliquant ces formules, on obtient pour la partie réelle du signal imaginaire :

$$S_r(t) = A_r \sin^2 \omega t \cos \varphi + A_j \cos^2 \omega t \sin \varphi + \sin \omega t \cos \omega t \, (A_r \sin \varphi + A_j \cos \varphi)$$

En faisant l'hypothèse que $\varphi = 0$, d'où $\cos\varphi = 1$ et $\sin\varphi = 0$, on obtient :

$$S_r(t) = A_r \sin^2 \omega t + A_j \sin \omega t \cos \omega t$$

et

$$\sin^2 \omega t = \frac{1}{2} - \frac{1}{2} \cos 2\omega t$$

$$\sin \omega t \cos \omega t = \frac{1}{2} \sin 2\omega t$$

Conformément à la figure 4, ce signal $S_r(t)$ est appliqué à un filtre passe-bas Fb d'une fréquence limite F/2, ce qui permet d'obtenir à la sortie le signal $S_r(t) = \dfrac{A_r}{2}$

On constate que la démodulation effectuée permet de retrouver le module de la partie réelle du signal S(t) à un facteur 2 près.
La démodulation de la partie imaginaire faite de la même manière permet d'obtenir

$$S_j(t) = \sin \omega t \cos \omega t \, (A_r \cos \varphi - A_j \sin \varphi) - A_r \sin^2 \omega t \sin \varphi + A_j \cos^2 \omega t \cos \varphi$$

En faisant l'hypothèse que $\varphi = 0$, d'où $\cos\varphi = 1$ et $\sin\varphi = 0$, on obtient :

$$S_j(t) = A_j \left( \frac{1}{2} + \frac{1}{2} \cos 2\omega t \right) + \frac{A_r}{2} \sin 2\omega t$$

Ce signal est appliqué à un filtre passe bas Fb de la fréquence f/2 et on obtient à la sortie le signal $S_j(t) = \dfrac{\overline{A_j}}{2}$

On constate que la démodulation effectuée permet de retrouver le module de la partie imaginaire de signal S (t) à un facteur 2 près.
Le processus de démodulation qui vient d'être décrit en se reportant à la figure 4, présuppose que le déphasage $\varphi$ est 0. Si ce n'est pas le cas, l'influence de l'angle $\varphi$ se traduit par :

$$S_r(t) = \frac{A_r}{2} \cos \varphi \ \text{ et } \ S_j(t) = \frac{A_j}{2} \cos \varphi$$

Comme il vient d'être décrit, le procédé proposé par l'invention implique cinq mesures permettant d'établir chaque fois une partie réelle et une partie imaginaire. Comme le montre le tableau, présente la séquence comporte trois mesures faites à la fréquence $f_1$ mais avec des inductions différentes, à savoir $B_{n-1}$, $B_n$ et $B_{n+1}$.

| Pas de mesure | Valeur de f | Valeur de B | Valeur de $V_p$ | Valeur mesurée | Grandeur stockée avant calcul | Grandeur calculée | Grandeur stockée après calcul |
|---|---|---|---|---|---|---|---|
| 1 | $f_1$ | $B_{n-1}$ | $KV_p$ | $R_{n-1}$ | $R_{n-1}$ | - | - |
| 2 | $f_1$ | $B_n$ | $V_p$ | $R_n = R_1$ $J_n = J_1$ | $R_1$ $J_1$ | - | - |
| 3 | $f_1$ | $B_{n+1}$ | $\dfrac{V_p}{k}$ | $R_{n+1}$ | $R_{n+1}$ | y $C_f$ $\varepsilon_1$ | y $\varepsilon_1$ |
| 4 | $K_0 f_1$ | $B_{n+1}$ | $\dfrac{V_p}{k}$ | $R'_{n+1}$ | $R'_{n+1}$ | - | - |
| 5 | $K_0 f_1$ | $B_n$ | $V_p$ | $R'_n = R_2$ $J'_n = j_2$ | $R_2$ $J_2$ | $C'_f$ $\varepsilon_2$ $L_x\omega$ $R_x$ $Z_x$ | $L_x\omega$ $R_x$ $Z_x$ |

Les inductions différentes s'obtiennent en appliquant aux bornes d'entrée du transformateur d'impédance les tensions respectivement $kV_p$, $V_p$ et $\dfrac{V_p}{k}$ , k étant une constante. Une quatrième mesure est effectuée à la fréquence $k_0 f_1$ avec la tension appliquée $\dfrac{V_p}{k}$ et une cinquième mesure à la fréquence $k_0 f_1$ et avec la tension $V_p$.

Comme le montre également le tableau, ce procédé permet de mesurer les parties réelle et imaginaire de l'expression $\dfrac{I_p}{V_p}$ , c'est-à-dire le courant primaire $I_p$ qui est représentatif de l'impédance de boucle à établir.

La première mesure effectuée à la fréquence $f_1$, avec la tension appliquée $kV_p$ permet de mesurer la partie réelle $R_{n-1}$ qui sera stockée, comme l'indique le tableau. La seconde mesure faite à la fréquence $f_1$ et avec la tension $V_p$ permet de mesurer les parties réelle $R_n$ et imaginaire $J_n$ appelées plus précisément $R_1$ et $J_1$. $R_1$ et $J_1$ seront stockés.

La troisième mesure faite à la fréquence $f_1$ et avec la tension $\dfrac{V_p}{k}$ fournit la partie réelle $R_{n+1}$, la quatrième mesure faite à la fréquence $k_0 f_1$ la partie réelle $R'_{n+1}$

Enfin, la cinquième mesure faite à la fréquence $k_0 f_1$ et avec la tension $V_p$ permet de mesurer $R'_n = R_2$ et $J_{1n}' = J_2$, $R_2$ et $J_2$ étant stockés.

Après avoir établi par mesure les grandeurs réelle et imaginaire R et J, le procédé selon l'invention prévoit l'établissement de l'impédance de boucle $Z_x$ par exploitation des grandeurs mesurées.

Les parties réelle $R_1$ et imaginaire $J_1$ obtenues à la fréquence $f_1$ et $R_2$ et $J_2$ obtenues à la fréquence $f_2$ sont définies par les équations suivantes :

$$R_1 = \frac{R_x}{N_p^2\left(R_x^2 + L_x^2\omega^2\right)} + C_{f_n} \qquad J_1 = \frac{L_x\omega}{N_p^2\left(R_x^2 + L_x^2\omega^2\right)} + \frac{1}{L_\mu\omega}$$

$$R_2 = \frac{R_x}{N_p^2\left(R_x^2 + k_0^2 L_x^2\omega^2\right)} + C'_{f_n} \qquad J_2 = \frac{k_0 L_x\omega}{N_p^2\left(R_x^2 + k_0^2 L_x^2\omega^2\right)} + \frac{1}{k_0 L_\mu\omega}$$

Par développement de ces équations connues en soi, on obtient les expressions

$$L_x\omega = \frac{\varepsilon_1 - \varepsilon_2}{N_p^2\varepsilon_1\varepsilon_2\left(k_0^2 - 1\right)} \frac{k_0^2\varepsilon_2 - \varepsilon_1}{k_0 J_2 - J_1}$$

$$R_x = L_x\omega\frac{k_0^2\varepsilon_2 - \varepsilon_1}{k_0 J_2 - J_1}$$

les termes $\varepsilon_1$ et $\varepsilon_2$ valant : $\varepsilon_1 = R_1 - C_{f_n}$ et $\varepsilon_2 = C'_{f_n}$

A partir des valeurs de $R_x$ et $L_x$, on calcule l'impédance $Z_x$ en ramenant l'impédance de la self à la fréquence du réseau, selon

$$k' = \frac{\text{fréquence du réseau}}{\text{fréquence de mesure}}$$

pour établir $Z_x = \sqrt{R_x^2 + k'^2 L_x^2\omega^2}$

La résolution des équations de $R_x$ et $L_x$ nécessite le calcul des termes $C_f$ et $C_f'$ qui représentent les pertes fer.

A partir des équations de départ suivantes :

$$R_n = \frac{R_x}{N_p^2\left(R_x^2 + L_x^2\omega^2\right)} + C_{f_n} = M + C_{f_n} \quad \text{avec} \quad M = \frac{R_x}{N_p^2\left(R_x^2 + L_x^2\omega^2\right)}$$

$$C_{f_n} = A_n C_{f_0}\left(\frac{B_n}{B_0}\right)^y = C_{f_0}\left(\frac{V_{p_n}^2}{V_{p_n}^2}\right)\left(\frac{B_n}{B_n}\right)^y = C_{f_0}$$

$$C_{f_{n+1}} = A_{n+1} C_{f_0}\left(\frac{B_{n+1}}{B_0}\right)^y = C_{f_0}\left(\frac{V_{p_n}^2}{V_{p_{n+1}}^2}\right)\left(\frac{B_{n+1}}{B_n}\right)^y = C_{f_0}\left(\frac{V_{p_n}^2}{k^2 V_{p_n}^2}\right)\left(\frac{kB_n}{B_n}\right)^y = C_{f_0}\frac{k^y}{k^2}$$

$$C_{f_{n-1}} = A_{n-1}C_{f_0}\left(\frac{B_{n-1}}{B_0}\right)^y = C_{f_0}\left(\frac{V_{p_n}^2}{V_{p_{n-1}}^2}\right)\left(\frac{B_{n-1}}{B_n}\right)^y = C_{f_0}\left(\frac{k^2 V_{p_n}^2}{V_{p_n}^2}\right)\left(\frac{B_n}{kB_n}\right)^y = C_{f_0}\frac{k^2}{k^y}$$

avec k étant le facteur de variation de l'induction B, donc de la tension primaire $V_p$. On obtient :

$$R_n - R_{n+1} = C_{f_0} - C_{f_0}\frac{k^y}{k^2} = C_{f_0}\left(1 - \frac{k^y}{k^2}\right)$$

$$R_{n-1} - R_n = C_{f_0}\frac{k^2}{k^y} \cdot C_{f_0} = C_{f_0}\left(\frac{k^2}{k^y} - 1\right)$$

Par division des deux équations, selon :

$$\frac{R_n - R_{n+1}}{R_{n-1} - R_n} = \frac{1 - \dfrac{k^y}{k^2}}{\dfrac{k^2}{k^y} - 1} = \frac{\dfrac{k^2 - k^y}{k^2}}{\dfrac{k^2 - k^y}{k^y}} = \frac{k^y}{k^2}$$

on obtient

$$k^y = k^2 \frac{R_n - R_{n+1}}{R_{n-1} - R_n}$$

et

$$y \log k = \log\left(k^2 \frac{R_n - R_{n+1}}{R_{n-1} - R_n}\right)$$

Ce qui permet d'établir :

$$y = 2 + \frac{\log\dfrac{R_n - R_{n+1}}{R_{n-1} - R_n}}{\log k}$$

Connaissant la valeur de y, on peut revenir à l'équation précédente, d'où l'on tire :

$$C_{f_0} = \frac{R_n - R_{n+1}}{1 - \dfrac{k^y}{k^2}}$$

Par analogie avec le calcul de $C_{f0}$, on obtient :

$$R'_n = \frac{R_x}{N_p^2\left(R_x^2 + k_0^2 L_x^2 \omega^2\right)} + C'_{f_0} = M' + C'_{f_0}$$

avec

$$M' = \frac{R_x}{N_p^2\left(R_x^2 + k_0^2 L_x^2 \omega^2\right)}$$

et

$$C'_{f_0} = \frac{R'_n - R'_{n+1}}{1 - \dfrac{k^y}{k^2}}$$

En effectuant les calculs selon les équations qui viennent d'être écrites et qui ont été obtenues par développement mathématique, on peut calculer les grandeurs y, $C_f$, $\varepsilon_1$, $C'_f$, $\varepsilon_2$, $L_{x\omega}$, $R_x$, $Z_x$ comme cela est indiqué dans l'avant-dernière colonne du tableau. Après le calcul, on stocke les grandeurs indiquées dans la dernière colonne, dont l'impédance de boucle $Z_x$.

**Revendications**

1. Procédé de mesure des résistances de terre d'installations électriques, par une mesure d'impédance de boucle, selon lequel on injecte à l'aide de moyens transformateurs générateurs de tension un courant dans la boucle et mesure ce courant à l'aide de moyens transformateurs de courant, **caractérisé en ce que** l'on fait exécuter les fonctions des deux moyens transformateurs par un seul transformateur utilisé comme transformateur d'impédance, effectue une pluralité de mesures permettant la détermination des pertes fer ($C_f$) du transformateur d'impédance et de l'image ($Y_\mu$) de l'inductance de magnétisation et établit l'impédance de boucle ($Z_x$) selon l'équation

$$\frac{I_p}{V_p} = C_f + Y_\mu + Y_x$$

$Y_x$ étant égal à $\dfrac{1}{Z_x}$ et $I_p$ étant le courant mesuré.

2. Procédé selon la revendication 1, **caractérisé en ce que** l'on effectue la pluralité de mesures avec des valeurs d'induction et de fréquence différentes.

3. Procédé selon la revendication 2, **caractérisé en ce que** l'on fait varier l'inductance par variation de la tension $V_p$ appliquée aux bornes d'entrée du transformateur.

4. Procédé selon l'une des revendications 1 à 3, **caractérisé en ce que** l'on mesure séparément la partie réelle et la partie imaginaire de la relation entre la tension d'entrée $V_p$ du transformateur et le courant $I_p$ injecté et calcule par exploitation des résultats de mesure les parties résistives et inductives de l'impédance à mesurer et la valeur même de cette impédance $Z_x$.

5. Procédé selon l'une des revendications 1 à 5, **caractérisé en ce que** l'on détermine les paramètres des parties réelle R et imaginaire J en faisant une pluralité de mesures, tout en maintenant la pince qui constitue le transformateur d'impédance fermé, au cours desquelles on fait varier l'inductance B, à une première fréquence $f_1$ et une deuxième fréquence $f2 = k_0 f_1$.

6. Procédé selon la revendication 5, **caractérisé en ce que** l'on fait trois mesures à la fréquence $f_1$ en faisant varier l'inductance B et au moins deux mesures à la fréquence $f_2$ en faisant varier l'inductance B.

7. Procédé selon l'une des revendications 4 à 6, **caractérisé en ce que** l'on sépare les parties réelle R et imaginaire J en appliquant sur le courant mesuré $I_p$ une double démodulation synchrone quadratique.

8. Procédé selon la revendication 1, **caractérisé en ce que** l'on effectue tout d'abord une mesure à vide pour déterminer les pertes de fer ($C_f$) et l'image de l'induction ($Y_\mu$) et ensuite une mesure de boucle et on établit la valeur de l'impédance de boucle ($Z_x$) en déduisant les valeurs de fer et de l'image de l'inductance en respectant les déphasages de chaque valeur.

**Claims**

1. A method for measuring earth resistances of electrical installations through a loop impedance measurement, wherein with voltage generating transformer means a current is coupled into the loop, and the current is measured with the current transformer means, **characterized in that** provision is made for the functions of both transformer means to be executed by a single transformer used as an impedance transformer, a plurality of measurements are made allowing for gap leakages ($C_f$) of the impedance transformer and the image ($Y_\mu$) of the magnetizing inductance to be determined, and the loop impedance ($Z_x$) is established according to the equation

$$\frac{I_p}{V_p} \;=\; C_f \;+\; Y_\mu \;+\; Y_x$$

with $Y_x$ equal to $\dfrac{1}{Z_x}$ , and $I_p$ the measured current.

2. The method according to claim 1, **characterized in that** the plurality of measurements is made with different induction and frequency values.

3. The method according to claim 2, **characterized in that** the inductance is varied by varying the voltage Vp applied across the transformer input.

4. The method according to any of claims 1 to 3, **characterized in that** the real part and the imaginary part of the relation between the input voltage $V_p$ of the transformer and the current $I_p$ coupled is measured separately, and by making use of the measurement results, the resistive and inductive parts of the impedance to be measured and the value as such of said impedance $Z_x$ are calculated.

5. The method according to any of claims 1 to 5, **characterized in that** the parameters of the real part R and the imaginary part J are determined by making a plurality of measurements, while maintaining closed the grip composed of the impedance transformer, during which the inductance B is varied at a first frequency $f_1$ and a second frequency $f_2 = k_0 f_1$.

6. The method according to claim 5, **characterized in that** three measurements are made at the frequency $f_1$ by varying the inductance B and at least two measurements are made at the frequency $f_2$ by varying the inductance B.

7. The method according to any of claims 4 to 6, **characterized in that** the real part R and the imaginary part J are separated by applying to the measured current $I_p$ a double square synchronous demodulation.

8. The method according to claim 1, **characterized in that** first of all, a blank measurement is made to determine the gap leakages ($C_f$) and the image of the induction ($Y_\mu$), and then a loop measurement is made, and the value of the loop impedance ($Z_x$) is established by deducting the gap and image values of the inductance while keeping the phase shifts of each value.

**Patentansprüche**

1. Verfahren zum Messen der Erdungswiderstände von elektrischen Anlagen durch Messung der Schleifenimpedanz, wobei mit Hilfe von spannungserzeugenden Wandlermitteln ein Strom in die Schleife eingekoppelt wird und dieser Strom anhand von Stromwandlermitteln gemessen wird, **dadurch gekennzeichnet, dass** veranlasst wird, dass die Funktionen der beiden Wandlermittel von einem einzigen Wandler ausgeführt werden, der als Impedanzwandler verwendet wird, dass eine Vielzahl von Messungen vorgenommen wird, die es ermöglichen, die Spaltverluste ($C_f$) des Impedanzwandlers und das Bild ($Y_\mu$) der Magnetisierungsinduktivität zu bestimmen, und dass die Schleifen-impedanz ($Z_x$) gemäß der Gleichung

$$\frac{I_p}{V_p} = C_f + Y_\mu + Y_x$$

erstellt wird, wobei $Y_x$ gleich $\dfrac{1}{Z_x}$, und $I_p$ der gemessene Strom ist.

2. Verfahren nach Anspruch 1, **dadurch gekennzeichnet, dass** die Vielzahl von Messungen mit verschiedenen Induktions- und Frequenzwerten ausgeführt wird.

3. Verfahren nach Anspruch 2, **dadurch gekennzeichnet, dass** die Induktivität durch Ändern der Spannung Vp geändert wird, die an den Klemmen des Wandlereingangs angelegt wird.

4. Verfahren nach einem der Ansprüche 1 bis 3, **dadurch gekennzeichnet, dass** der Realteil und der Imaginärteil der Beziehung zwischen der Eingangsspannung $V_p$ des Wandlers und dem eingekoppelten Strom $I_p$ getrennt gemessen werden, und dass unter Verwendung der Messergebnisse die resistiven und induktiven Teile der zu messenden Impedanz und der eigentliche Wert dieser Impedanz $Z_x$ berechnet werden.

5. Verfahren nach einem der Ansprüche 1 bis 5, **dadurch gekennzeichnet, dass** die Parameter des Realteils R und des Imaginärteils J bestimmt werden, indem eine Vielzahl von Messungen ausgeführt werden und dabei die Klammer, die durch den Impedanzwandler gebildet wird, geschlossen gehalten wird, während denen die Induktivität B auf einer ersten Frequenz $f_1$ und einer zweiten Frequenz $f_2 = k_0 f_1$ verändert wird.

6. Verfahren nach Anspruch 5, **dadurch gekennzeichnet, dass** drei Messungen auf der Frequenz $f_1$ durch Ändern der Induktivität B und mindestens zwei Messungen auf der Frequenz $f_2$ durch Ändern der Induktivität B ausgeführt werden.

7. Verfahren nach einem der Ansprüche 4 bis 6,
**dadurch gekennzeichnet, dass** der Realteil R und der Imaginärteil J getrennt werden, indem auf den gemessenen Strom Ip eine doppelte quadratische Synchrondemodulation angewendet wird.

8. Verfahren nach Anspruch 1, **dadurch gekennzeichnet, dass** zuerst eine Blindmessung vorgenommen wird, um die Spaltverluste ($C_f$) und das Bild ($Y_\mu$) der Induktion zu bestimmen, und dann eine Schleifenmessung vorgenommen wird, und der Wert der Schleifenimpedanz ($Z_x$) durch Abziehen des Spaltwertes und des Bildwertes der Induktivität unter Einhaltung der Phasenverschiebung jedes Wertes erstellt wird.

Fig.1

Fig.2

Fig.3

Ip

Vp $\uparrow$   Rf   L$\mu$   Zx.Np$^2$

Z

_Fig. 4_

Fb

s(t)

$\otimes$ → Filtre passe-bas f/2 → Sr(t) = Ar/2

$m_r(t) = \sin \omega t$

90°   $m_j(t) = \cos \omega t$

Fb

$\otimes$ → Filtre passe-bas f/2 → Sj(t) = Aj/2

_Fig. 5_

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 06222093 A